# EUROPÄISCHE PATENTANMELDUNG

(11) **EP 2 147 739 A2**
(43) Veröffentlichungstag der Anmeldung: **27.01.2010**
(21) Anmeldenummer: 09008711.5
(22) Anmeldetag: 03.07.2009
(51) Int. Cl.: B23K 35/02, H01B 1/22, H01L 21/60

(54) **Edelmetall basiertes Verbindungsmittel in Folienform mit einem Feststoffanteil und einem Flüssiganteil, sowie Herstellungs- und Verwendungsverfahren hierzu**

(30) Priorität: 26.07.2008 DE 102008034946
(71) Anmelder: Semikron Elektronik GmbH & Co. KG Patentabteilung, 90431 Nürnberg (DE)
(72) Erfinder: Tobias, Fey, 91058 Erlangen (DE)

(57) **Zusammenfassung**

Die Erfindung beschreibt ein Edelmetallverbindungsmittel in Folienform, sein Herstellungsverfahren sowie ein Verfahren zur Anwendung. Das Edelmetallverbindungsmittel weist eine Feststoffanteil und einen Flüssiganteil mit einem zugeordneten Mischungsverhältnis in Volumenprozent von 99,8:0,2 bis 95:5 der beiden auf, wobei der Feststoffanteil einen Volumenanteil an einer ersten Komponente Silber von mindestens 60% aufweist und wobei der Flüssiganteil aus einer Lösungsmittelkomponente und mindestens einem hierin gelösten organischen Bindemittel besteht. Die erste Komponente des Feststoffanteils liegt als Partikel mit einer Längenabmessung zwischen 50nm und 20µm liegt. Die Herstellung der Folie erfolgt nach einem Foliengussverfahren und deren Verwendung in der Ausbildung einer stoffschlüssigen Verbindung durch Wärmeeinwirkung.

## Beschreibung

Die Erfindung beschreibt ein Edelmetallverbindungsmittel sowie ein Verfahren zu dessen Herstellung wie auch zu dessen Verwendung, wodurch zwei Verbindungspartner stoffschlüssig und elektrisch leitend miteinander verbunden werden.

Beispielhaft gemäß der DE 34 14 065 C2 oder der DE 10 2005 058 794 A1 ist es bekannt zwei Verbindungspartner mit jeweils einer Edelmetalloberfläche stoffschlüssig zu verbinden und hierzu ein Verbindungsmittel zu verwenden, welches aus Silberpartikeln besteht, die mit einer Flüssigkeit, häufig Terpiniol, vermischt werden. Es ist weiterhin bekannt, dass die zu verbindenden Oberflächen zumindest überwiegend aus Edelmetall bestehen müssen.

Zur Ausbildung der Verbindung wird die Mischung aus Silber und Terpiniol auf eine der beiden zu verbindenden Oberflächen aufgetragen, der zweite Verbindungspartner angeordnet und die gesamte Anordnung mit Druck in der Größenordnung von 40MPa und bei einer Temperatur von bevorzugt mindestens 250°C beaufschlagt. Die hierdurch entstehende elektrisch leitende stoffschlüssige Verbindung weist eine hohe Festigkeit und Langzeitstabilität auf.

Nachteilig an den genannten Verbindungen ist, dass der hohe Druck nicht für jeden beliebigen Verbindungspartner anwendbar ist, oder zumindest in der Anwendung hohe Anforderungen stellt um beispielhaft bei der Verbindung eines Metalls mit einem Silizumchip diesen nicht zu beschädigen.

Bekannt ist weiterhin ein Verfahren gemäß der DE10 2004 056 702 A1 bei dem das bekannte Verbindungsmittel in einem Sprühverfahren auf eine Folie aufgebracht wird, anschließend die Flüssigkeit möglichst vollständig ausgetrieben wird und das dann fast reine Silber, noch immer in Partikelform, auf einer zu verbindenden Fläche angeordnet wird. Nachteilig hierbei ist, dass die derart hergestellten Silberplättchen äußerst empfindlich gegen mechanische Zerstörung sind.

Der Erfindung liegt die Aufgabe zugrunde ein Edelmetallverbindungsmittel ein Verfahren zu dessen Herstellung sowie ein Verfahren zu dessen Verwendung vorzustellen, das einer einfachen Handhabung zugänglich ist und wobei die notwendige Temperatur zur Ausbildung der Verbindung ebenfalls reduziert werden kann.

Diese Aufgabe wird erfindungsgemäß gelöst, durch ein Edelmetallverbindungsmittel mit den Merkmalen des Anspruchs 1, sowie durch ein zugeordnetes Verwendungsverfahren nach Anspruch 8. Bevorzugte Ausführungsformen sind in den abhängigen Ansprüchen beschrieben.

Ausgangspunkt der Erfindung sind bekannte Edelmetallverbindungsmittel bestehend aus einer Mischung aus Silberpartikeln als Feststoffanteil und einem Flüssigkeit, vorzugsweise Terpiniol als Flüssiganteil. Erfindungsgemäß wird dieses Edelmetallverbindungsmittel dahingehend weitergebildet, dass es in Folienform vorliegt und somit wesentlich besser verarbeitet werden kann. Hierzu weist das Edelmetallverbindungsmittel einem Feststoffanteil und einem Flüssiganteil mit einem zugeordneten Mischungsverhältnis in Volumenprozent von 99,8:0,2 bis 95:5. Hierbei liegen die Silberpartikel oder auch weitere Komponenten des Feststoffanteils als Partikel mit Längenabmessungen zwischen 50nm und 20µm vor

Der Feststoffanteil seinerseits weist mindestens als eine Komponente Silber in Partikelform auf, mit einen Volumenanteil am Feststoffanteil von mindestens 60%. Es kann allerdings bevorzugt sein, wenn der Feststoffanteil neben der genannten Komponente noch mindestens eine weitere Komponente mit einem Volumenanteil von weniger als 40% aufweist. Diese weitere Komponente sind vorzugsweise Metallpartikel der oben genannten Größe aus Kupfer, Gold oder Platin. Alternativ kann diese weitere Komponente auch ein Element der 3. Hauptgruppe (Borgruppe) des Periodensystems sein oder eine Mischung dieser genannten Stoffen. Ein Anteil Silberoxid als weitere Komponente oder als Teil der weiteren Komponente kann ebenso besonders bevorzugt sein. Es ist ebenso vorteilhaft zumindest die Silberpartikel oder auch die Partikel der weiteren Komponente des Feststoffanteils mit einer organischen Passivierungsschicht zu überziehen. Hierdurch wird beispielhafte ein ungewollte Reaktion des Edelmetallverbindungsmittels, speziell des Silbers, mit Luftsauerstoff vermieden.

Erfindungswesentlich ist, dass das erfindungsgemäße Edelmetallverbindungsmittel anstelle der bekannten Flüssigkeiten, wie beispielhaft Terpiniol, zur Bildung der Mischung mit dem Feststoffanteil, einen Flüssiganteil bestehend aus einer Lösungsmittelkomponenten und mindestens einem hierin gelösten organischen Bindemittel, vorzugsweise Polyvinylacetat oder Polyvinylbutyral, aufweist. Als mögliche Lösungsmittel für Polyvinylacetat oder Polyvinylbutyral bieten sich verschiedene Alkohole, Ketone oder Ester an. Bei weiteren bevorzugten Bindemitteln, beispielhaft Polyvinylalkohol oder dessen teilverseiften Kopoloymeren bietet sich Wasser als ein ideales Lösungsmittel an.

Das erfindungsgemäße Verfahren zur Herstellung eines oben beschriebenen Edelmetallverbindungsmittel in Folienform weist die folgenden wesentlichen Schritte auf:
- Aufbringen des Edelmetallverbindungsmittels mit einem aktuellen Mischungsverhältnis in Volumenprozent des Feststoffteils zum Flüssiganteil von 95:5 bis 70:30, also mit hohem Feuchteanteil, auf einer Transportvorrichtung. Hierbei wird das Edelmetallverbindungsmittel in flüssiger Form aufgebracht und durch eine geeignete Vorrichtung die Dicke der späteren Folie bestimmt.
- Annährend vollständiges Austreiben, vorzugsweise mittels Erwärmung, des Lösungsmittels aus dem Edelmetallverbindungsmittel während des Transports auf der Transportvorrichtung.
- Abnahme der Folie von der Transportvorrichtung, wobei nun das oben genannten Mischungsverhältnis des Feststoffanteil zu dem Flüssiganteil ein Volumenprozent von 99,8:0,2 bis 95:5, also einen geringe Feuchteanteil, aufweist.

Die erfindungsgemäße Verwendung einer derartigen Folie ist gekennzeichnet durch die folgenden wesentlichen Schritte:
- Herstellung von mindestens eines an die Abmessungen der zu verbindenden Flächen zweier Verbindungspartner angepassten Folienabschnitts. Hierbei wird die Folie aus dem Edelmetallverbindungsmittel vorzugsweise mittels einer Zerteilvorrichtung, wie einer Schneide- oder Laserzerteilvorrichtung, in die Folienabschnitte geteilt.
- Anordnung des mindestens einen Folienabschnitts des Edelmetallverbindungsmittels auf einer ersten metallischen Oberfläche eines ersten Verbindungspartners. Hierbei ist es natürlich bevorzugt wenn diese Oberfläche einen Edelmetallanteil von mehr als 90% aufweist. Zur Anordnung dieser Schicht hat sich das grundsätzlich aus der Leiterplattenfertigung bekannte pick- and place- Verfahren als besonders zweckmäßig erwiesen, da die Folie vergleichsweise unempfindlich gegen Berührung ist. Weiterhin ist es vorteilhaft die Folie oder die Oberfläche des ersten Verbindungspartners zu benetzen, wozu sich das bereits in der Edelmetallverbindungseinrichtung vorhandenen Lösungsmittel besonders eignet.
- In einem fakultativen Schritt kann es bevorzugt sein den Folienabschnitt mit einem Plasma zu beaufschlagen und diese somit zu aktivieren. Hierbei eignet sich besonders ein Sauerstoff-, Stickstoff- oder Formiergasplasma, wobei das sauerstoffhaltige Plasma bevorzugt ist.
- Anordnung eines zweiten Verbindungspartners mit einer zweiten Oberfläche auf dieser Schicht, wobei diese Oberfläche bevorzugt ebenfalls einen Edelmetallanteil von mehr als 90% aufweist. Auch hier kann es bevorzugt sein die Folie oder die zweite Oberfläche des zweiten Verbindungspartners in oben geschilderter Weise zu benetzen.
- Temperaturbeaufschlagung, bevorzugt mittels Induktionsverfahren oder mittels Mikrowellenanregung, der Folie mit einer Temperatur zwischen 170°C und 230°C, wodurch eine elektrisch leitende stoffschlüssige Verbindung der beiden Verbindungspartner entsteht.
- In einem weiteren fakultativen zeitlich mit der Temperaturbeaufschlagung zusammenfallenden Verfahrensschritt werden die beiden Verbindungspartner und die dazwischen angeordnete Folie aus dem Edelmetallverbindungsmittel mit Druck beaufschlagt, wobei hier allerdings eine Druckbeaufschlagung mit weniger als 5MPa ausreichend ist.

Das erfindungsgemäße Verfahrens zu Verwendung des Edelmetallverbindungsmittels in Folienform ist auf Grund dieser Ausprägung als Folie relativ Unempfindlichkeit gegen mechanische Belastung. Somit ist es möglich das Edelmetallverbindungsmittel auch dann auf einer ersten Oberfläche des ersten Verbindungspartners anzuordnen, wenn diese Oberfläche eine dreidimensionale erste Kontur vorzugsweise mit nur einer Krümmungsrichtung aufweist. Konsequenterweise weist dann die zweite Oberfläche des zweiten Verbindungspartners eine hieran angepasste zweite Kontur auf.

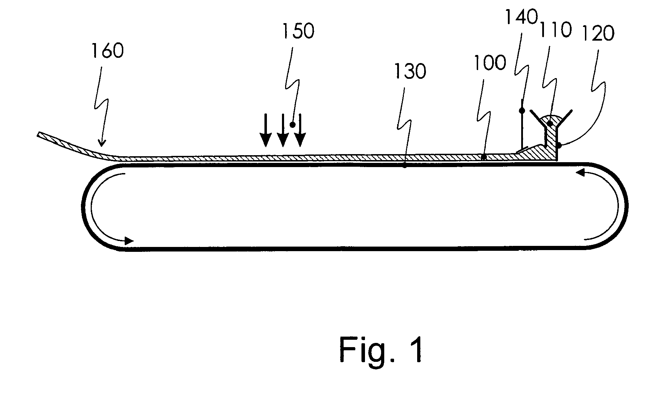

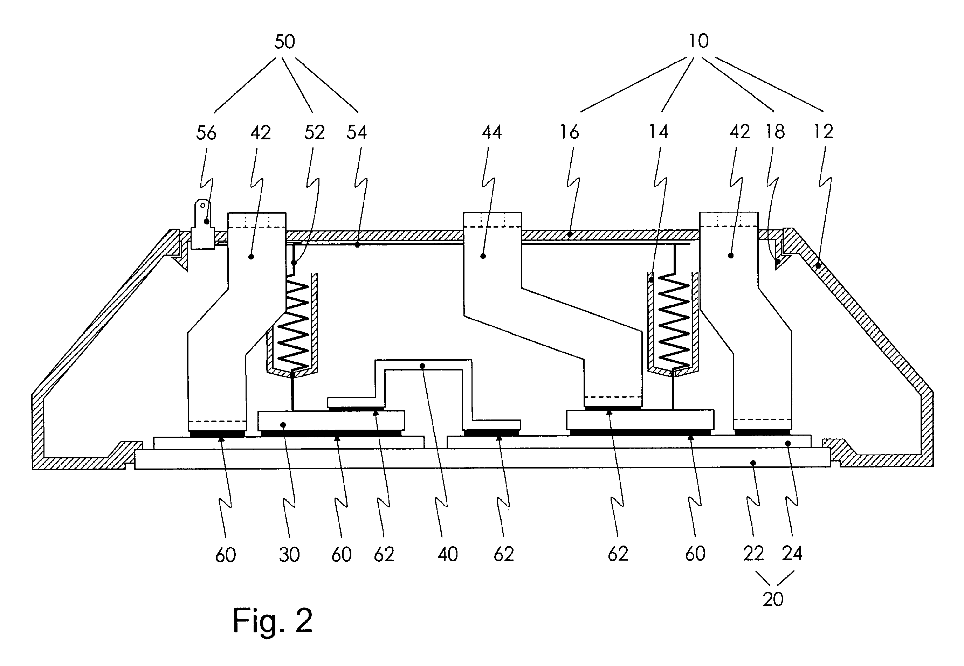

Besonders bevorzugte Weiterbildungen der erfindungsgemäßen Herstellung und Verwendung dieses Edelmetallverbindungsmittel sind in der jeweiligen Beschreibung des folgenden Ausführungsbeispiels genannt. Die erfinderische Lösung wird zudem an Hand der Fig. 1 und 2 weiter erläutert.

Fig. 1 zeigt schematisch ein Herstellungsverfahren eines erfindungsgemäßen Edelmetallverbindungsmittel in Folienform (100), wobei die Herstellung in Grundzügen dem keramischen Folienguss entspricht. Das Edelmetallverbindungsmittel (110) mit hohem Feuchteanteil wird mittels eines Gusstisches (120) auf eine Transporteinrichtung (130) aufgebracht und an einem Schwert (140) zur Bestimmung der Foliendicke vorbei transportiert. Die Dicke der Folie in diesem Zustand liegt vorzugsweise zwischen 15µm und 600µm. Im weiteren Verlauf der Transporteinrichtung (130) wird ein wesentlicher Anteil des Lösungsmittels, vorzugsweise durch thermische Einwirkung (150) ausgetrieben, wodurch sich die Dicke auf Werte zwischen 10µm und 500µm verringert. In diesem Zustand kann die Folie (100) von der Transportvorrichtung (120) abgenommen (160) und direkt im Anschluss oder auch nach einer Wartezeit in Folienabschnitte (60, 62 vgl. Fig. 2) konfektioniert werden.

Fig. 2 zeigt ein Leistungshalbleitermodul im Längsschnitt hergestellt mittels der erfindungsgemäßen Verwendung des genannten Edelmetallverbindungsmittels. Dargestellt ist hier ein Substrat (20), vorzugsweise bestehend aus einer Industriekeramik (22) wie Aluminiumoxid oder Aluminiumnitrid. Hierauf sind mittels bekannter Verfahren, wie beispielhaft des DCB- Verfahrens metallische Schichten auf einer oder beiden Hauptflächen der Keramik (22) aufgebracht. Die dem Inneren des Leistungshalbleitermoduls angeordnete metallische Schicht ist hierbei in sich strukturiert und bildet einzelne elektrisch isolierte Leiterbahnen (24).

Auf diesen Leiterbahnen (24) sind zwei Leistungshalbleiterbauelemente (30), beispielhaft Leistungsthyristoren, Leistungstransistoren und / oder Leistungsdioden, angeordnet. Die elektrisch leitende Verbindung zwischen den Leiterbahnen (24) und den Leistungshalbleiterbauelementen (30) besteht aus der erfindungsgemäßen Edelmetallverbindungsmittel (60, 62) mit einer Schichtdicke von ca. 50µm nach seiner Verwendung, bei der ein wesentlicher Teil des Flüssigkeitsanteils durch die Temperaturbeaufschlagung ausgetrieben ist.

Zur schaltungsgerechten Verbindung der Leistungshalbleiterbauelemente (30) dienen metallische Verbindungselemente (40), die mittels Stanz- Biegetechniken hergestellt wurden. Hier wird die dem Substrat (20) abgewandte Leistungskontaktfläche eines Leistungshalbleiterbauelements (30) mit einer Leiterbahn (24) des Substrats (20) verbunden. Ebenso sind Verbindungen zwischen mindestens zwei Leistungshalbleiterbauelementen (30) oder zwischen mindestens zwei Leiterbahnen (24) möglich, wenn die schaltungsgerechte Verbindung dies erfordert. Die elektrisch leitenden Verbindungen (60, 62) dieser Verbindungselemente (40) mit Leistungshalbleiterbauelementen (30) und / oder Leiterbahnen (24) sind ebenfalls mittels der erfindungsgemäßen Verwendung des Edelmetallverbindungsmittels hergestellt.

Die Lastanschlusselemente (42, 44) bestehen ebenso wie die Verbindungselemente (40) aus Stanz- Biegeelementen. Hier dargestellt sind zwei Lastanschlusselemente (42), die von Leiterbahnen (24) nach außen führen sowie ein Lastanschlusselement (44), das von einem Halbleiterbauelement (30) nach außen führt. Diese Lastanschlusselemente (42, 44) dienen somit der externen Kontaktierung. Auch die elektrisch leitenden Verbindungen (60, 62) dieser Lastanschlusselement (42, 44) mit Leistungshalbleiterbauelementen (30) und / oder Leiterbahnen (24) erfolgt gemäß der erfindungsgemäßen Verwendung des Edelmetallverbindungsmittels.

Zu rationellen Herstellung des Verbundes aus Substrat (20), Leistungshalbleiterbauelementen (30), Verbindungs- (40) und Lastanschlusselementen (42, 44) können alle diese Elemente sowie das notwendige Edelmetallverbindungsmittel zueinander angeordnet werden und anschließend mittels des erfindungsgemäßen Verfahrens die elektrisch leitenden stoffschlüssigen Verbindungen hergestellt werden. Der wesentliche Vorteil gegenüber dem Stand der Technik ist hier, dass auf eine Druckeinleitung verzichtet werden kann, wodurch auch die Lastanschlusselemente einfach zu verbinden sind, da hier eine Druckeinleitung technisch nur schwierig realisierbar ist.

Anschießend wird ein erstes Gehäuseteil (12) derart angeordnet, dass es das Substrat (20) umschließt und überdeckt. Das Gehäuseteil (12) selbst weist Führungen (14) auf, in denen die Kontaktfedern (52) der Hilfsanschlüsse (50) angeordnet und in ihrer Position fixiert sind. Ein Deckel (16), als weiterer Teil des Gehäuses (10), weist an seiner dem Gehäuseinneren zugewandten Seite Verbindungsbahnen (54) auf, Diese Verbindungsbahnen (54) weisen ein erstes Ende auf und sind dort mit jeweiligen Metallformteilen (56) verbunden, die den Deckel (16) durchdringen und an der Außenseite als Stecker ausgebildet sind und der Verbindung der Hilfssignale dienen. Die als Kontaktfeder (52) ausgebildeten inneren Abschnitte der Hilfsanschlüsse (50) enden auf dem jeweils zweiten Ende der Verbindungsbahnen (54) des Deckels (16). Um diese Verbindung wie auch die Verbindung mit den Hilfskontaktflächen der Leistungshalbleiterbauelemente (30) sicher zu stellen wird die Kontaktfeder (52) durch den Gehäusedeckel (16) mit Druck beaufschlagt. Die wird durch Schnapp-Rastverbindungen (18) des Deckels (16) mit dem ersten Gehäuseteil (12) erreicht.

## Patentansprüche

1. Edelmetallverbindungsmittel in Folienform mit einem Feststoffanteil und einem Flüssiganteil mit einem zugeordneten Mischungsverhältnis in Volumenprozent von 99,8:0,2 bis 95:5 der beiden,
wobei der Feststoffanteil einen Volumenanteil an einer ersten Komponente Silber von mindestens 60% aufweist und wobei der Flüssiganteil aus einer Lösungsmittelkomponente und mindestens einem hierin gelösten organischen Bindemittel besteht,
wobei die erste Komponente des Feststoffanteils als Partikel mit einer Längenabmessung zwischen 50nm und 20µm vorliegt.

2. Edelmetallverbindungsmittel nach Anspruch 1,
wobei die Lösungsmittelkomponente ein Alkohol, ein Keton, ein Ester, Wasser oder eine Mischung aus mindestens zwei dieser Lösungsmittel ist.

3. Edelmetallverbindungsmittel nach Anspruch 1,
wobei das organische Bindemittel Polyvinylacetat, Polyvinylbutyral, Polyvinylalkohol oder eine dessen teilverseiftes Kopoloymer ist.

4. Edelmetallverbindungsmittel nach Anspruch 1,
wobei der Feststoffanteil mindestens eine weitere Komponente, einen metallischen Stoff und/oder ein Metalloxid, mit einem Gesamtvolumenanteil von bis zu 40% aufweist.

5. Edelmetallverbindungsmittel nach Anspruch 4,
wobei die weitere Komponente Kupfer, Gold, Platin, ein Element der 3. Gruppe des Periodensystems oder eine Mischung hieraus ist.

6. Edelmetallverbindungsmittel nach Anspruch 1 oder 4,
wobei die Partikel der erste Komponente und/oder mindestens einer weiteren Komponenten des Feststoffanteils mit einer organischen Passivierungsschicht überzogen sind.

7. Verfahren zur Herstellung aus eines Edelmetallverbindungsmittel in Folienform nach einem der Ansprüche 1 bis 6 **gekennzeichnet durch** die folgenden Schritte:
• Aufbringen des Edelmetallverbindungsmittels mit einem Mischungsverhältnis in Volumenprozent des Feststoffteils zum Flüssiganteil von 95:5 bis 70:30 auf einer Transportvorrichtung;
• Annährend vollständiges Austreiben des Lösungsmittels aus dem Edelmetallverbindungsmittel;
• Abnahme der Folie von der Transportvorrichtung.

8. Verfahren zur Verwendung einer Folie nach Anspruch 7 **gekennzeichnet durch** die folgenden Schritte:
• Herstellung von mindestens eines an die Abmessungen der zu verbindenden Flächen zweier Verbindungsparten angepassten Folienabschnitts;
• Anordnung des mindestens einen Folienabschnitts auf einer ersten Oberfläche des ersten Verbindungspartners;
• Anordnen des zweiten Verbindungspartners mit seiner zweiten Oberfläche auf dem Folienabschnitt.
• Temperaturbeaufschlagung des Folienabschnitts mit einer Temperatur zwischen 170°C und 230°C zur Ausbildung einer elektrisch leitenden stoffschlüssigen Verbindung der beiden Verbindungspartner.

9. Verfahren nach Anspruch 8,
wobei die Temperaturbeaufschlagung mittels Induktionsverfahren oder mittels Mikrowellenanregung erfolgt.

10. Verfahren nach Anspruch 8,
wobei zusätzlich zur Temperaturbeaufschlagung eine Druckbeaufschlagung der beiden Verbindungspartner mit dazwischen angeordnetem Folienabschnitt mit weniger als 5MPa erfolgt.

11. Verfahren nach Anspruch 8,
wobei die erste und zweite Oberfläche als eine metallische Oberfläche mit einem Edelmetallanteil von mehr als 90% ausgebildet sind.

12. Verfahren nach Anspruch 8,
wobei vor Anordnung des zweiten Verbindungspartners der mindestens eine Folienabschnitt mit einem Plasma aktiviert wird.

13. Verfahren nach Anspruch 13,
wobei ein Sauerstoff-, Stickstoff- oder Formiergasplasma verwendet wird.

14. Verfahren nach Anspruch 8,
wobei vor der Anordnung des Folienabschnitts auf dem ersten Verbindungspartner dessen mindestens eine erste Oberfläche oder der Folienabschnitt selbst mit einem Lösungsmittel benetzt wird.

15. Verfahren nach Anspruch 8,
wobei vor der Anordnung des zweiten Verbindungspartners dessen zweite Oberfläche oder der Folienabschnitt mit einem Lösungsmittel benetzt wird.

16. Verfahren nach Anspruch 14 oder 15,
wobei das Lösungsmittel identisch ist mit demjenigen Lösungsmittel des Edelmetallverbindungsmittels.

17. Verfahren nach Anspruch 8,
wobei die erste Oberfläche des ersten Verbindungspartners eine dreidimensionale erste Kontur aufweist und die zweite Oberfläche des zweiten Verbindungspartners eine hieran angepasste zweite Kontur aufweist.

18. Verfahren nach Anspruch 8,
wobei der mindestens eine Folienabschnitt mittels eine pic- and- place- Verfahrens auf der ersten Oberfläche angeordnet wird.
